# EUROPEAN PATENT APPLICATION

(11) **EP 2 980 266 A1**
(43) Date of publication of application: **03.02.2016**
(21) Application number: 14773509.6
(22) Date of filing: 07.03.2014
(51) Int. Cl.: C23C 14/24, B82Y 40/00

(54) **NANOPARTICLE DIFFERENTIATION DEVICE**

(30) Priority: 25.03.2013 JP 2013062254
(71) Applicant: Atsumitec Co., Ltd., Hamamatsu-shi, Shizuoka 433-8118 (JP)
(72) Inventor: UCHIYAMA, Naoki, Hamamatsu-shi Shizuoka 433-8118 (JP)
(74) Representative: MERH-IP Matias Erny Reichl Hoffmann Patentanwälte PartG mbB
(86) International application number: PCT/JP2014/055989
(87) International publication number: WO 2014/156565

(57) **Abstract**

A nanoparticle differentiation device 1 includes: a plurality of chambers 9 that are linearly arranged, and divided from each other by partitions 5; a generation chamber 2 that is provided with a material 4 to be vaporized; a plurality of film forming chambers 3a to 3c that are provided with respective substrates 7 on which nanoparticles 8a to 8c generated from the material 4 are film-formed; a plurality of communication tubes 6 that are provided to penetrate the respective partitions 5 in order to cause the adjoining chambers 9 to communicate with each other; a gas introducing tube 10 that communicates with the generation chamber 2 in order to introduce cooling gas; and a vacuum tube 14 that communicates with a high vacuum chamber 13 that is a chamber 9 arranged at a position farthest from the generation chamber 2, i.e., the film forming chamber 3c, among the chambers 9 in order to perform evacuation.

## Description

### Technical Field

The present invention relates to a nanoparticle differentiation device.

### Background Art

A hyper-fine particle film forming method and a hyper-fine particle film forming device are described in Patent Document 1. This device generates vapor atoms from a material, conveys the vapor atoms with an inert gas through a conveyance tube, and forms a hyper-fine particle film on a substrate. In other words in general representation, such a particle film forming device and method are provided with chambers at upper and lower positions, and a narrow tube through which the chambers communicate with each other. The upper chamber is evacuated, and cooling gas is caused to flow into the lower chamber. The vaporized metal is cooled and moves into the upper chamber by a pressure difference. The metal is collected on the substrate in the upper chamber in a particle state. The cooling gas is, for example, helium or argon gas. The flow of the gas prevents particles from cohesion and grain growth.

Unfortunately, the particle diameters vary; the diameters of particles formed from the vaporized material are approximately determined by the pressure and cooling capability during vaporization and by the velocity of the flow of particles caused by the differential pressure between a vaporization chamber and a collecting chamber. The device described in Patent Document 1 can only comprehensively collect the particles with varying particle diameters, but cannot collect the particles in a differentiated manner according to the particle diameters.

### Prior Art Document

### Patent Document

Patent Document 1: Japanese Patent Application Laid-Open Publication No. 2000-297361

### Summary of the Invention

### Problems to be solved by the Invention

The present invention has been made in view of the conventional technique, and has an object to provide a nanoparticle differentiation device that can differentiate and collect nanoparticles with different particle diameters obtained from a single material.

### Means for Solving the Problems

In order to achieve the object, the present invention provides a nanoparticle differentiation device including: a plurality of chambers that are linearly arranged, and divided from each other by partitions; a generation chamber that is provided with a material to be vaporized, and is a chamber among the chambers and arranged at one end; a plurality of film forming chambers that are provided with respective substrates on which nanoparticles generated from the material are film-formed, and are the chambers other than the generation chamber among the chambers; a plurality of communication tubes that are provided to penetrate the respective partitions in order to cause the adjoining chambers to communicate with each other; a gas introducing tube that communicates with the generation chamber in order to introduce cooling gas; and a vacuum tube that communicates with a high vacuum chamber that is a chamber arranged at a position farthest from the generation chamber among the chambers in order to perform evacuation.

### Advantageous Effects of the Invention

According to the present invention, the high vacuum chamber is evacuated. Consequently, the film forming chambers divided by the partitions cause pressure differences. That is, according to the pressure differences, the pressure gradually increases, among the chambers, from the high vacuum chamber to the generation chamber. Consequently, particles with large particle diameters, which are heavy particles, remain in the chamber that has a high pressure and far from the high vacuum chamber. On the contrary, particles with the lowest particle diameters, which are light particles, reach the high vacuum chamber with a low pressure. Accordingly, the nanoparticles that have been generated from a single material and have different particle diameters can be differentiated and collected. Here, the communication tubes are arranged in an ascending order of the inner diameters from the high vacuum chamber toward the generation chamber, thereby allowing the film forming chambers to be efficiently provided with the pressure differences. Alternatively, the film forming chambers may be arranged in an ascending order of the volumes toward the generation chamber, thereby allowing the film forming chambers to be efficiently provided with the pressure differences. Alternatively, a temperature adjuster that increases the temperatures of the film forming chambers as approaching the generation chamber may be provided, thereby allowing the film forming chambers to be efficiently provided with the pressure differences. The axes of the adjoining communication tubes are configured to be deviate from each other, thereby allowing the nanoparticles to be efficiently collected.

### Brief Description of the Drawings

FIG. 1 is a schematic diagram of a particle differentiation device according to the present invention.
FIG. 2 is a schematic diagram of another particle differentiation device according to the present invention.
FIG. 3 is a schematic diagram of still another particle differentiation device according to the present invention.

### Mode for Carrying out the Invention

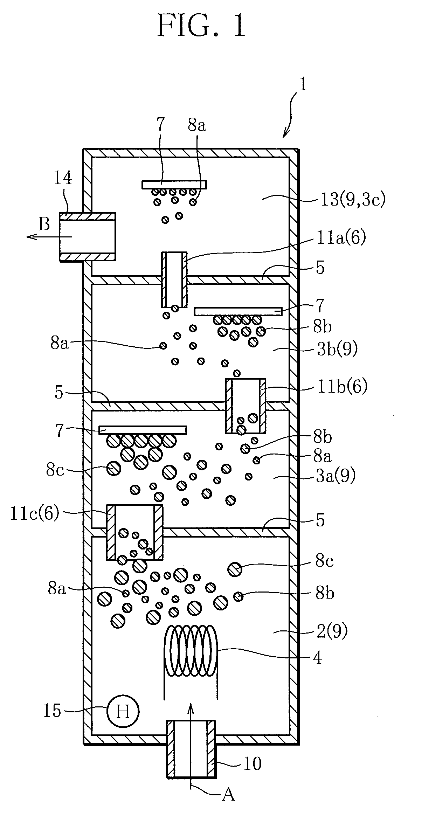

As shown in FIG. 1, a nanoparticle differentiation device 1 according to the present invention includes linearly arranged multiple chambers 9. These chambers 9 are separated from each other by partitions 5. A chamber 9 arranged on one end among these chambers 9 is formed as a generation chamber 2. In the generation chamber 2, a material 4 to be vaporized is arranged. In an illustrated embodiment, metal wire wound into a coil is represented as the material 4. In the case of adopting the metal wire as the material 4, this material may be, for example, magnesium or nickel or an alloy of magnesium and nickel. The material 4 is not necessarily metal. Alternatively, this material may be any of resin and oxides. In the case of adopting resin as the material 4, the resin may be, for example, nylon resin, polyvinylpyrrolidone (PVP), polyethylene oxide (PEO) or the like.

Furthermore, the generation chamber 2 is provided with a heater 15. The heater 15 is for heating the material 4. The heater 15 may be a crucible, a plasma generator or the like. The material 4 is heated by the heater 15 to be vaporized, thereby generating nanoparticles 8a to 8c. Furthermore, the generation chamber 2 communicates with the outside through a gas introducing tube 10. Cooling gas, such as helium or argon gas, is introduced through the gas introducing tube 10 (the direction of arrow A in FIG. 1). Introduction of the cooling gas prevents the nanoparticles from colliding with each other and thereby prevents the particle diameters from increasing (grain growth).

Among the chambers 9 described above, all the chambers 9 other than the generation chamber 2 are formed as film forming chambers 3a to 3c. The film forming chambers 3a to 3c are provided with substrates 7, respectively. The nanoparticles 8a to 8c generated from the material 4 are collected by the respective substrates 7 to form films. The chamber 9 (film forming chamber 3c) arranged at a position farthest from the generation chamber 2 is formed as a high vacuum chamber 13. That is, the high vacuum chamber 13 is referred to as the chamber 9 and also as the film forming chamber 3c. The high vacuum chamber 13 communicates with the outside through a vacuum tube 14. The high vacuum chamber 13 is evacuated through the vacuum tube 14 by, for example, an exhaust fan or the like (the direction of arrow B in FIG. 1).

Here, the partitions 5 that divide the generation chamber 2 and the film forming chambers 3a to 3c, which are all the chambers 9, from each other are provided with communication tubes 6 penetrating through the respective partitions. Consequently, all pairs of adjoining chambers 9 communicate with each other through the respective communication tubes 6. When the high vacuum chamber 13 is evacuated as described above, the other film forming chambers 3a and 3b and the generation chamber 2 that communicate with the high vacuum chamber 13 are also evacuated. All the chambers 9 communicate with each other only through the communication tubes 6. Consequently, pressure differences occur among the chambers 9. The pressure differences cause the nanoparticles 8a to 8c generated in the generation chamber 2 to rapidly flow into the adjoining film forming chamber 3a through the communication tube 6.

In order to effectively cause such pressure differences, the embodiment in FIG. 1 adopts the communication tubes 6 having different inner diameters. The communication tube 6 themselves have linear forms with respective uniform inner diameters. The communication tubes 6 are, however, arranged in an ascending order of the inner diameters from the high vacuum chamber 13 toward the generation chamber 2. That is, in the case of four chambers 9 as shown in FIG. 1, three communication tubes 11a to 11c with different inner diameters are prepared as the communication tubes 6 penetrating the respective partitions 5. These tubes are arranged in the order from the communication tube 11a with the smallest inner diameter to the tube 11c with the largest inner diameter so as to increase the inner diameter from the high vacuum chamber 13 toward the generation chamber 2 (arrangement in the order of the communication tubes 11a, 11b and 11c from the high vacuum chamber 13 toward the generation chamber 2). Consequently, the chambers 9 become low vacuum from the high vacuum chamber 13 toward the generation chamber 2. The degree of vacuum of the generation chamber 2 is the lowest.

The above configuration allows nanoparticles with different particle diameters to be differentiated and collected. First, the material (metal wire in the example in FIG. 1) 4 is arranged in the generation chamber 2. The cooling gas (cooling gas containing helium or argon gas) is introduced through the gas introducing tube 10 into the generation chamber 2. While the cooling gas is introduced, the heater 15 is operated to heat the material 4. At this time, evacuation is performed through the vacuum tube 14, which communicates with the high vacuum chamber 13. The material 4 is then vaporized, thereby obtaining the nanoparticles 8a to 8c. Not all the generated nanoparticles have the same diameter. In the example in FIG. 1, the sizes of the nanoparticles are classified into three types, to which symbols 8a to 8c are assigned, and description is made. The nanoparticles 8a to 8c are thus generated in a vapor phase environment. Consequently, even if the material 4 is made of metal that is susceptible to oxidation, for example, magnesium or the like, unnecessary oxidation can be prevented.

Introduction of the cooling gas causes the generated nanoparticles 8a to 8c to move to the adjoining film forming chamber 3a through the communication tube 11c (6) by evacuation from the high vacuum chamber 13 while the particle diameters are maintained approximately the same. The film forming chamber 3a adjoining to the generation chamber 2 is further affected by evacuation from the high vacuum chamber 13. However, the nanoparticles 8c belonging to the largest particle diameter group cannot move to the next adjoining film forming chamber 3b through the communication tube 11b because of their weights. Consequently, in the film forming chamber 3a adjoining to the generation chamber 2, only the nanoparticles 8c remain, but only nanoparticles 8a and 8b with smaller diameters can move to the next adjoining film forming chamber 3b. The nanoparticles 8c remaining in the film forming chamber 3a are film-formed on the substrate 7 arranged in the film forming chamber 3a. Consequently, only the nanoparticles 8c with the approximately same diameters can be film-formed on the substrate 7 arranged in the film forming chamber 3a and thus collected.

The nanoparticles 8a and 8b move into the film forming chamber 3b as described above. The film forming chamber 3b is further affected by the evacuation from the high vacuum chamber 13 (film forming chamber 3c). However, the nanoparticles 8b cannot move to the high vacuum chamber 13 through the communication tube 11a because of being affected by the weights due to the sizes of the particle diameters. Consequently, only the nanoparticles 8b remain in the film forming chamber 3b. Only the nanoparticles 8a with the smaller diameters move into the high vacuum chamber 13. The nanoparticles 8b remaining in the film forming chamber 3b are film-formed on the substrate 7 arranged in the film forming chamber 3b. Consequently, only the nanoparticles 8b with the approximately same particle diameters can be film-formed on the substrate 7 arranged in the film forming chamber 3b and thus collected.

Only the nanoparticles 8a belonging to the smallest particle diameter group reach the high vacuum chamber 13. These nanoparticles 8a are film-formed on the substrate 7 arranged in the high vacuum chamber 13. Consequently, only the nanoparticles 8a with the approximately the same particle diameters can be film-formed on the substrate 7 arranged in the high vacuum chamber 13 and thus collected.

As described above, in the nanoparticle differentiation device 1, the high vacuum chamber 13 is evacuated. Consequently, pressure differences occur between the multiple film forming chambers 3a to 3c divided by the partitions 5. That is, the pressure differences occur where the pressures gradually increase in the multiple chambers 9 from the high vacuum chamber 13 to the generation chamber 2. Consequently, the particles 8c with large particle diameters, which are heavy particles, remain in the chamber that has a high pressure and is far from the high vacuum chamber 13. On the contrary, the light particles 8a with the smallest particle diameters reach the high vacuum chamber 13 having a low pressure. Consequently, the nanoparticles 8a to 8b that have been obtained from the single material but have different particle diameters can be differentiated and collected. Here, the communication tubes 11a to 11c are arranged in the ascending order of the inner diameters from the high vacuum chamber 13 toward the generation chamber 2, thereby enabling the multiple film forming chambers 3a to 3c to be efficiently provided with the pressure differences. As illustrated in FIG. 1, the multiple communication tubes 11a to 11c provided through the respective partitions 5 are arranged so as to have axes deviating from each other. Consequently, the substrates 7 can be arranged immediately above the respective communication tubes 11a to 11c, thereby allowing the nanoparticles 8a to 8c to be efficiently collected. After the nanoparticles 8a to 8c are sufficiently film-formed on the respective substrates 7, the substrates 7 are replaced and then films are newly formed.

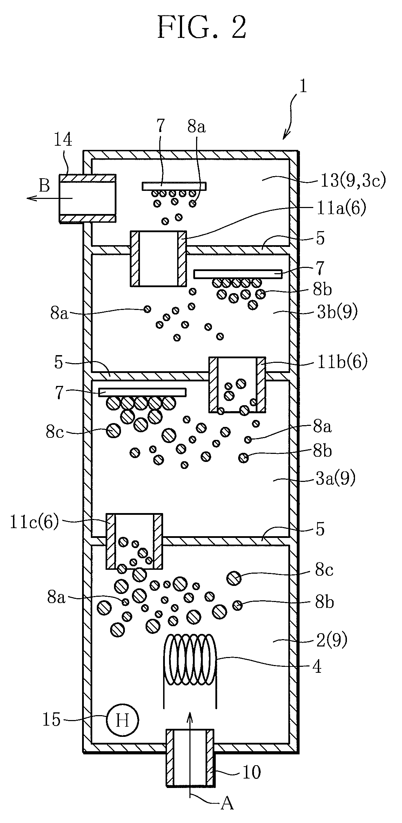

As described above, if different pressure differences occur between the film forming chambers 3a to 3c, the nanoparticles 8a to 8c can be effectively differentiated according to the particle diameters and film-formed, thus being collected. To achieve this, the communication tubes 11a to 11c with different diameters as shown in FIG. 1 may be adopted. In the example in FIG. 1, the film forming chambers 3a to 3c have the same volume. Accordingly, the communication tubes 11a to 11c with the different diameters are adopted to cause the pressure differences between the film forming chambers 3a to 3c. Alternatively, other measures may be adopted. As shown in FIG. 2, the film forming chambers 3a to 3c may be configured to have different volumes, thereby causing the pressure differences. In this case, the communication tubes 6 that cause the film forming chambers 3a to 3c to communicate with each other may have the same inner diameter. The film forming chamber 3c, which is the high vacuum chamber 13, may have the smallest volume. The volumes may be increased in the order from the film forming chamber 3b to the film forming chamber 3a as approaching the generation chamber 2, thereby allowing the film forming chambers 3a to 3c to be effectively provided with pressure differences. If the nanoparticles 8a to 8c are generated according to the same method as described above with the same device configuration, the nanoparticles 8a to 8c can be differentiated and collected according to the particle diameters.

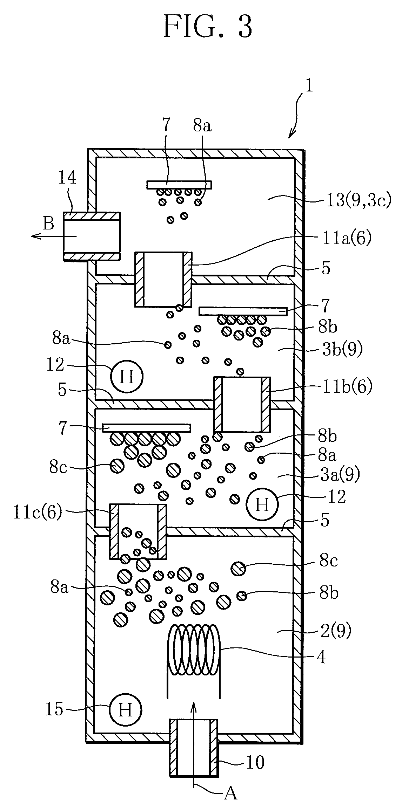

As other measures for causing the pressure differences between the film forming chambers 3a to 3c, heaters 12 may be provided in the respective film forming chambers 3a and 3b as shown in FIG. 3. In this case, the film forming chambers 3a to 3c are configured to have the same volume. All the communication tubes 6 are configured to have the same inner diameter. The heaters 12 set the temperatures of the film forming chambers 3a to 3c to be increased as approaching the generation chamber 2. That is, the high vacuum chamber 13 (film forming chamber 3c) is set to have the lowest temperature. From the film forming chamber 3c, the adjoining film forming chambers are set to have temperatures in a sequentially increasing manner. The film forming chamber 3a is set to have the highest temperature. Consequently, in the example in FIG. 3, the film forming chamber 3c may have the lowest temperature. Accordingly, this chamber is provided with no heater 12. As described above, the temperature differences provided between the film forming chambers 3a to 3c can also effectively provide the film forming chambers 3a to 3c with the pressure differences. If the nanoparticles 8a to 8c are generated according to the method analogous to that described above with such a device configuration, the nanoparticles 8a to 8c are differentiated and collected according to the particle diameters. Instead of the heaters 12, cooling gas blowers may be provided in the film forming chambers 3a to 3c as necessary (a configuration with no blower in the film forming chamber 3a may be adopted), and the temperatures may be adjusted as described above. That is, if the film forming chambers 3a to 3c have the same volume and the communication tubes 6 have the same inner diameter, a temperature adjuster allowing the film forming chambers 3a to 3c to have different temperatures may be provided to cause the pressure differences between the film forming chambers 3a to 3c.

The pressure differences may be provided between the film forming chambers 3a to 3c by combining the configurations of the examples in FIGS. 1 to 3 described above.

### <Aspect of Present Invention>

In order to achieve the object, the present invention provides a nanoparticle differentiation device, including: a plurality of chambers that are linearly arranged, and divided from each other by partitions; a generation chamber that is provided with a material to be vaporized, and is a chamber among the chambers and arranged at one end; a plurality of film forming chambers that are provided with respective substrates on which nanoparticles generated from the material are film-formed, and are the chambers other than the generation chamber among the chambers; a plurality of communication tubes that are provided to penetrate the respective partitions in order to cause the adjoining chambers to communicate with each other; a gas introducing tube that communicates with the generation chamber in order to introduce cooling gas; and a vacuum tube that communicates with a high vacuum chamber that is a chamber arranged at a position farthest from the generation chamber among the chambers in order to perform evacuation.

Preferably, the communication tubes have linear shapes with respective uniform diameters, and the communication tubes have different inner diameters so as to be arranged in ascending order of the inner diameters from the high vacuum chamber toward the generation chamber.

Preferably, the film forming chambers have respective volumes so as to be arranged in an ascending order of the volumes toward the generation chamber.

Preferably, the film forming chambers are provided with a temperature adjuster for increasing temperatures of the film forming chambers as approaching the generation chamber.

Preferably, the adjoining communication tubes are arranged to have axes that deviate from each other.

### Explanation of Reference Signs

- 1: Nanoparticle differentiation device
- 2: Generation chamber
- 3: Film forming chamber
- 4: Material
- 5: Partition
- 6: Communication tube
- 7: Substrate
- 8a to 8c: Nanoparticles
- 9: Chamber
- 10: Gas introducing tube
- 11a to 11c: Communication tube
- 12: Heater (temperature adjuster)
- 13: High vacuum chamber
- 14: Vacuum tube
- 15: Heater

## Claims

1. A nanoparticle differentiation device, comprising:
a plurality of chambers that are linearly arranged, and divided from each other by partitions;
a generation chamber that is provided with a material to be vaporized, and is a chamber among the chambers and arranged at one end;
a plurality of film forming chambers that are provided with respective substrates on which nanoparticles generated from the material are film-formed, and are the chambers other than the generation chamber among the chambers;
a plurality of communication tubes that are provided to penetrate the respective partitions in order to cause the adjoining chambers to communicate with each other;
a gas introducing tube that communicates with the generation chamber in order to introduce cooling gas; and
a vacuum tube that communicates with a high vacuum chamber that is a chamber arranged at a position farthest from the generation chamber among the chambers in order to perform evacuation.

2. The nanoparticle differentiation device according to claim 1, wherein the communication tubes have linear shapes with respective uniform diameters, and the communication tubes have different inner diameters so as to be arranged in ascending order of the inner diameters from the high vacuum chamber toward the generation chamber.

3. The nanoparticle differentiation device according to claim 1, wherein the film forming chambers have respective volumes so as to be arranged in an ascending order of the volumes toward the generation chamber.

4. The nanoparticle differentiation device according to claim 1, wherein the film forming chambers are provided with a temperature adjuster for increasing temperatures of the film forming chambers as approaching the generation chamber.

5. The nanoparticle differentiation device according to claim 1, wherein the adjoining communication tubes are arranged to have axes that deviate from each other.
